# FASCICULE DE BREVET EUROPEEN

(11) **EP 0 949 745 B1**
(45) Date de publication et mention de la délivrance du brevet: **11.08.2004**
(21) Numéro de dépôt: 99400851.4
(22) Date de dépôt: 08.04.1999
(51) Int. Cl.: H02K 11/04, H05K 3/32, H05K 3/30

(54) **Substrat pour un sous-ensemble à composant électronique de machine électrique**
Substrat für eine Baugruppe von elektronischen Bauteilen einer elektrischer Maschine
Substrate for a subassembly of electronic components of an electric machine

(30) Priorité: 09.04.1998 FR 9804449
(43) Date de publication de la demande: 13.10.1999
(73) Titulaire: VALEO EQUIPEMENTS ELECTRIQUES MOTEUR, 94000 Créteil (FR)
(72) Inventeur: van den Bossche, Mathieu, 75020 Paris (FR)
(74) Mandataire: Le Forestier, Eric

(56) Documents cités:
- EP-A- 0 210 090
- EP-A- 0 312 802
- DE-C- 669 696
- DE-C- 4 233 679
- DE-U- 9 212 744
- US-A- 3 849 838

## Description

La présente invention concerne les substrats pour sous-ensemble à composant électronique pour machine électrique.

On connaît un substrat pour composants électroniques de type diodes, transistors, plaquettes de circuits intégrés ou circuits hybrides comprenant une ou plusieurs traces métalliques sur lesquelles est surmoulé un matériau plastique isolant. Un tel substrat est plus particulièrement destiné à des porte-balais régulateurs et des ponts de diodes pour alternateurs de véhicules automobiles. Les composants de puissance sont brasés ou collés sur des dissipateurs permettant d'évacuer les calories par convection ou par conduction. Les lignes de courant ou les mises sous potentiel se font par les traces métalliques, issues par exemple de matriçage, sur lesquelles est surmoulée la matière plastique isolante. Le choix du matériau de surmoulage correspond à des demandes techniques propres à l'utilisation ultérieure du produit dans l'application. Une de ces demandes particulières est la tenue au fluage, c'est-à-dire la conservation d'une épaisseur mise en contrainte après des stress climatiques, ce qui permet par exemple de garantir un couple de desserrage entre une vis et un écrou. Pour répondre à ce besoin de tenue au fluage, on peut choisir une matière plastique haut de gamme présentant les caractéristiques mécaniques requises. Toutefois, une telle matière plastique est coûteuse, ce qui augmente le prix de revient du substrat.

Le document DE-4 233 679 divulgue un substrat conforme au préambule de la revendication 1.

Un but de l'invention est de fournir un substrat moins coûteux mais assurant une fixation durable du sous-ensemble à la machine.

En vue de la réalisation de ce but, on prévoit selon l'invention un substrat selon la revendication 1.

Ainsi, on peut choisir les deux matières plastiques pour les adapter le mieux possible aux parties respectives. La partie de fixation pourra par exemple être une matière plastique haut de gamme présentant une bonne tenue au fluage en vue d'une fixation durable du sous-ensemble à la machine en dépit de variations climatiques. La partie de réception pourra être une matière plastique ayant des caractéristiques mécaniques moyennes. Cette dernière matière plastique ayant un coût plus bas que la première, on abaisse le prix de revient du substrat sans nuire aux performances mécaniques.

Le substrat pourra également présenter une ou plusieurs des caractéristiques suivantes :
- le sous-ensemble est un porte-balais ;
- le sous-ensemble est un pont redresseur ;
- la machine est un alternateur pour véhicule.

Des modes de réalisation particuliers sont énoncés dans les autres revendications.

D'autres caractéristiques et avantages de l'invention apparaîtront encore dans la description suivante d'un mode préféré de réalisation donné à titre d'exemple non limitatif. Aux dessins annexés :
- la figure 1 est une vue en coupe transversale d'un sous-ensemble selon l'invention ; et
- la figure 2 est une vue analogue montrant le sous-ensemble monté sur une partie de la machine.

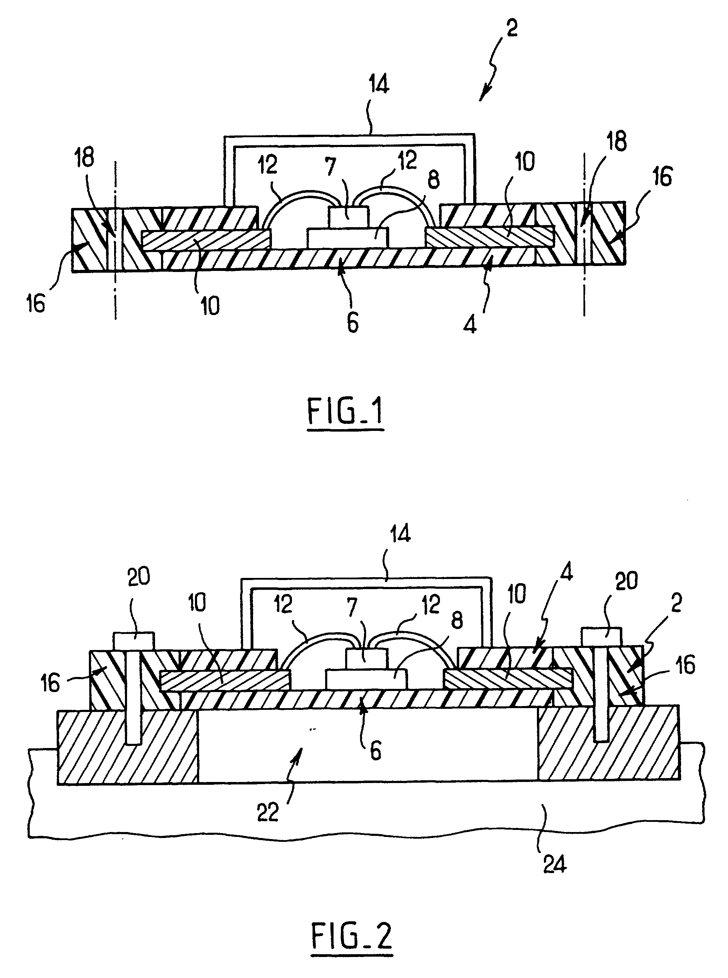

Le sous-ensemble de la figure 1 est un pont redresseur ou un porte-balais pour alternateur de véhicule automobile. Plus généralement, il pourra s'agir d'un sous-ensemble comportant un ou plusieurs composants électroniques tels que des diodes, des transistors, des plaquettes de circuits imprimés ou des circuits hybrides.

Le sous-ensemble 2 comporte un substrat 4 présentant une partie 6 de réception d'un ou plusieurs composants électroniques 7 par l'intermédiaire d'une embase 8. Le substrat 4 a une forme générale plate. Il comporte des conducteurs électriques 10, ici sous la forme de traces métalliques, s'étendant dans l'épaisseur du substrat 4 et connectant, au moyen de câblages 12, le composant 7 à un connecteur non représenté du sous-ensemble. Un capot 14 recouvre la partie de réception 6 du composant 7 pour isoler celui-ci de l'extérieur.

Le substrat 4 présente des parties de fixation 16, telles que des pattes, présentant chacune un conduit 18 s'étendant suivant l'épaisseur du substrat 4. Ces parties 16 sont destinées à recevoir des vis 20 pour la fixation du substrat 4 à un support 22 appartenant à une machine électrique 24 telle qu'un alternateur de véhicule.

Le substrat 4 est fabriqué par surmoulage sur les traces métalliques 10 d'une première matière plastique définissant la partie de réception 6, et d'une deuxième matière plastique, différente de la première, définissant les seules parties de fixation 16. Les deux matières plastiques peuvent être comoulées ou moulées l'une sur l'autre successivement. On choisit pour la première matière plastique un matériau peu coûteux ayant des caractéristiques mécaniques moyennes. Pour la deuxième matière plastique, on choisit une matière plastique haut de gamme telle qu'un polysulfure de phénylène, ayant une excellente tenue au fluage. Ainsi, après serrage des vis 20, les parties de fixation 16 se trouvent comprimées entre les têtes de vis et le support 22. Avec le temps, cette compression demeure sensiblement inchangée en dépit de variations climatiques, ce qui assure la pérennité du serrage des vis 20.

On pourra modifier la forme du substrat 4. On pourra employer pour le réaliser au moins trois matières plastiques différentes.

## Revendications

1. Substrat (4) pour un sous-ensemble (2) de machine électrique, présentant une partie (6) de réception d'un composant électronique (7), réalisée en matière plastique, et une partie de fixation (16) du substrat à la machine, réalisée en matière plastique, **caractérisé en ce que** les matières plastiques des parties de réception (6) et de fixation (16) sont différentes et
**en ce que** la matière plastique de la partie de fixation (16) présente une résistance au fluage plus importante que la matière plastique de la partie de réception (6).

2. Substrat selon la revendication 1, **caractérisé en ce qu'**il comprend des conducteurs électriques (10) sur lesquels au moins l'une des matières plastiques est surmoulée.

3. Substrat selon la revendication 2, **caractérisé en ce que** les conducteurs (10) sont des traces.

4. Substrat selon l'une quelconque des revendications 1 à 3, **caractérisé en ce que** la matière plastique de la partie de fixation (16) est un polysulfure de phénylène.

5. Substrat selon l'une quelconque des revendications 1 à 4, **caractérisé en ce qu'**il comprend un capot (14) recouvrant la partie de réception (6) et distinct de la partie de fixation (16).

6. Substrat selon l'une quelconque des revendications 1 à 5, **caractérisé en ce qu'**il a une forme générale plate.

7. Substrat selon la revendication 6, **caractérisé en ce que** les parties de fixation (16) comprennent chacune un conduit (18) s'étendant suivant l'épaisseur du substrat.

8. Substrat selon la revendication 7, **caractérisé en ce que** les parties de fixation sont destinées à recevoir des vis (20).

9. Substrat selon l'une quelconque des revendications précédentes, **caractérisé en ce que** la partie de fixation (16) comporte une patte.

10. Substrat selon l'une quelconque des revendications précédentes, **caractérisé en ce que** les parties de réception et de fixation sont comoulées ou moulées l'une sur l'autre successivement.

## Patentansprüche

1. Substrat (4) für eine Baugruppe (2) einer elektrischen Maschine mit einem aus Kunststoff ausgeführten Aufnahmeteil (6) zur Aufnahme eines elektronischen Bauteils (7) und einem aus Kunststoff ausgeführten Befestigungsteil (16) zur Befestigung des Substrats an der Maschine, **dadurch gekennzeichnet, daß** die Kunststoffe der Aufnahme- (6) und Befestigungsteile (16) verschieden sind und daß der Kunststoff des Befestigungsteils (16) eine höhere Standfestigkeit als der Kunststoff des Aufnahmeteils (6) aufweist.

2. Substrat nach Anspruch 1, **dadurch gekennzeichnet, daß** es elektrische Leiter (10) umfaßt, auf denen wenigstens einer der Kunststoffe aufgeformt ist.

3. Substrat nach Anspruch 2, **dadurch gekennzeichnet, daß** die Leiter (10) Bahnen sind.

4. Substrat nach einem der Ansprüche 1 bis 3, **dadurch gekennzeichnet, daß** der Kunststoff des Befestigungsteils (16) ein Phenylenpolysulfid ist.

5. Substrat nach einem der Ansprüche 1 bis 4, **dadurch gekennzeichnet, daß** es eine Abdeckkappe (14) umfaßt, die den Aufnahmeteil (6) abdeckt und vom Befestigungsteil (16) verschieden ist.

6. Substrat nach einem der Ansprüche 1 bis 5, **dadurch gekennzeichnet, daß** es eine flache Gesamtform aufweist.

7. Substrat nach Anspruch 6, **dadurch gekennzeichnet, daß** die Befestigungsteile (16) jeweils einen Kanal (18) umfassen, der sich entlang der Dicke des Substrats erstreckt.

8. Substrat nach Anspruch 7, **dadurch ge-kennzeichnet, daß** die Befestigungsteile zur Aufnahme von Schrauben (20) bestimmt sind.

9. Substrat nach einem der vorangehenden Ansprüche **dadurch gekennzeichnet, daß** die Befestigungsteile einen Ansatz umfassen.

10. Substrat nach einem der vorangehenden Ansprüche, **dadurch gekennzeichnet, daß** die Aufnahmeund Befestigungsteile zusammen geformt oder nacheinander aufeinander geformt sind.

## Claims

1. A substrate (4) for an electrical machine subassembly (2), having a portion (6) made of plastics material for receiving an electronic component (7), and a fastening portion (16) made of plastics material for fastening the substrate to the machine, **characterised in that** the plastics materials of the receiving portion (6) and the fastening portion (16) are different, and **in that** the plastics material of the fastening portion (16) has greater resistance to plastic flow than the plastics material of the receiving portion (6).

2. A substrate according to Claim 1, **characterised in that** it includes electrical conductors (10) on which at least one of the plastics materials is moulded *in situ.*

3. A substrate according to Claim 2, **characterised in that** the conductors (10) are in the form of tracks.

4. A substrate according to any one of Claims 1 to 3, **characterised in that** the plastics material of the fastening portion (16) is a phenylene polysulphate.

5. A substrate according to any one of Claims 1 to 4, **characterised in that** it includes a cap (14) overlying the receiving portion (6) and separate from the fastening portion (16).

6. A substrate according to any one of Claims 1 to 5, **characterised in that** it is of generally flat form.

7. A substrate according to Claim 6, **characterised in that** each of the fastening portions (16) includes a passage (18) extending along the thickness of the substrate.

8. A substrate according to Claim 7, **characterised in that** the fastening portions are adapted to receive screws (20).

9. A substrate according to any one of the preceding Claims, **characterised in that** the fastening portion (16) includes a lug.

10. A substrate according to any one of the preceding Claims, **characterised in that** the receiving and fastening portions are co-moulded, or moulded successively one over the other.
